# FASCICULE DE BREVET EUROPEEN

(11) **EP 1 199 803 B1**
(45) Date de publication et mention de la délivrance du brevet: **11.01.2006**
(21) Numéro de dépôt: 01203814.7
(22) Date de dépôt: 09.10.2001
(51) Int. Cl.: H03L 5/00

(54) **Asservissement en amplitude d'un signal alternatif produit par un dispositif électronique, tel un circuit oscillateur**
Amplitudenregelung eines durch eine elektronische Vorrichtung beispielsweise durch einen Oszillator erzeugten Wechselsignals
Amplitude controling of an alternating signal produced by an electronic device such as an oscillator circuit

(30) Priorité: 17.10.2000 EP 00203593
(43) Date de publication de la demande: 24.04.2002
(73) Titulaire: ASULAB S.A., 2074 Marin (CH)
(72) Inventeur: Casagrande, Arnaud, 2523 Lignières (CH)
(74) Mandataire: Laurent, Jean

(56) Documents cités:
- WO-A-93/09592
- US-A- 3 828 270
- US-A- 4 083 237
- US-A- 4 194 164

## Description

La présente invention se rapporte à un dispositif électronique asservi en amplitude, tel un circuit oscillateur, destiné à produire un signal de sortie alternatif d'amplitude sensiblement constante conformément au préambule de la revendication indépendante 1.

Une solution permettant d'asservir l'amplitude d'un signal de sortie alternatif produit par un dispositif électronique, tel un circuit oscillateur, consiste typiquement à pourvoir le dispositif électronique d'une boucle d'asservissement en amplitude. Cette boucle d'asservissement en amplitude comprend typiquement une branche de mesure destinée à produire une tension de mesure représentative de l'amplitude du signal de sortie, tension de mesure qui est comparée à une valeur de référence afin de produire un signal de commande, ou signal d'asservissement, qui est appliqué au dispositif électronique dans le but d'asservir l'amplitude du signal de sortie à une valeur déterminée.

Un désavantage d'une telle solution réside dans le fait que la branche de mesure permettant de produire la tension de mesure représentative de l'amplitude du signal de sortie présente communément une sensibilité aux variations de température ainsi qu'une sensibilité aux variations de processus de fabrication. Cette sensibilité se répercute directement sur le signal d'asservissement de sorte que l'on ne peut garantir une amplitude constante du signal de sortie avec une telle solution.

Un but principal de la présente invention est donc de proposer un dispositif électronique dont l'asservissement en amplitude du signal de sortie est substantiellement indépendant des variations de températures et de processus de fabrication, notamment.

On notera que le document US 3,828,270 décrit déjà un dispositif électronique asservi en amplitude répondant au but principal susmentionné. Ce document décrit un dispositif produisant un signal de sortie alternatif et comprenant une branche de mesure destinée à produire une tension de mesure représentative de l'amplitude du signal de sortie alternatif, une branche de référence pour produire une tension de référence et des moyens de comparaison pour comparer les tensions de mesure et de référence et produire un signal d'asservissement de l'amplitude du signal de sortie. Les branches de mesure et de références sont appariées de manière à présenter des sensibilités similaires aux variations de température et de processus de fabrication. dispositif utilise néanmoins une source additionnelle pour produire la tension de référence ainsi que des atténuateurs pour permettre le réglage de la valeur de cette tension de référence, les caractéristiques de ces atténuateurs devant être réglés à la main.

Un autre but de la présente invention est ainsi de proposer une solution qui soit plus simple de conception que les solutions de l'art antérieur et qui soit en particulier adaptée pour des applications à faible consommation.

L'invention a ainsi pour objet un dispositif électronique asservi en amplitude dont les caractéristiques sont énoncées dans la revendication indépendante 1.

Des modes de réalisations avantageux font l'objet des revendications dépendantes.

Selon l'invention, la tension de référence est ainsi produite en sortie d'une branche de référence appariée à la branche de mesure permettant de produire la tension de mesure représentative de l'amplitude du signal de sortie du dispositif électronique, cette tension de référence étant en particulier obtenue par commutation d'une référence de tension à l'entrée de la branche de mesure. L'appariement des branches de mesure et de référence a pour résultat que les sensibilités aux variations de température et de processus de fabrication de ces tensions sont sensiblement égale de sorte que le signal d'asservissement produit en réponse à la comparaison de ces tensions est, lui, sensiblement indépendant de ces variations.

La fréquence de commutation de la référence de tension peut en particulier être choisie plus faible que la fréquence du signal alternatif délivré en sortie du dispositif électronique, réduisant ainsi la consommation du système d'asservissement.

Selon l'invention, la fréquence de commutation de la référence de tension est dérivée de la fréquence du signal de sortie alternatif produit par le dispositif électronique. De la sorte, il n'est pas nécessaire de faire appel à une source additionnelle pour la génération de la tension de référence.

D'autres caractéristiques et avantages de la présente invention apparaîtront plus clairement à la lecture de la description détaillée qui suit, faite en référence aux dessins annexés donnés à titre d'exemples non limitatifs et dans lesquels :
- la figure 1 montre un schéma de principe d'un premier mode de réalisation de la présente invention employant des transistors MOS appariés fonctionnant en régime de faible inversion;
- la figure 2 montre un schéma de principe d'un second mode de réalisation de la présente invention employant des transistors bipolaires appariés,
- la figure 3 montre un exemple schématique de réalisation de la présente invention basé sur le principe illustré à la figure 2 et appliqué à l'asservissement en amplitude d'un oscillateur ; et
- les figures 4 et 5 montrent deux exemples de réalisation de moyens de détection d'oscillation pour détecter l'activité du dispositif électronique et, dans l'éventualité où le dispositif électronique ne délivre pas de signal de sortie alternatif, pour agir sur ledit signal d'asservissement afin de permettre un démarrage du dispositif électronique.

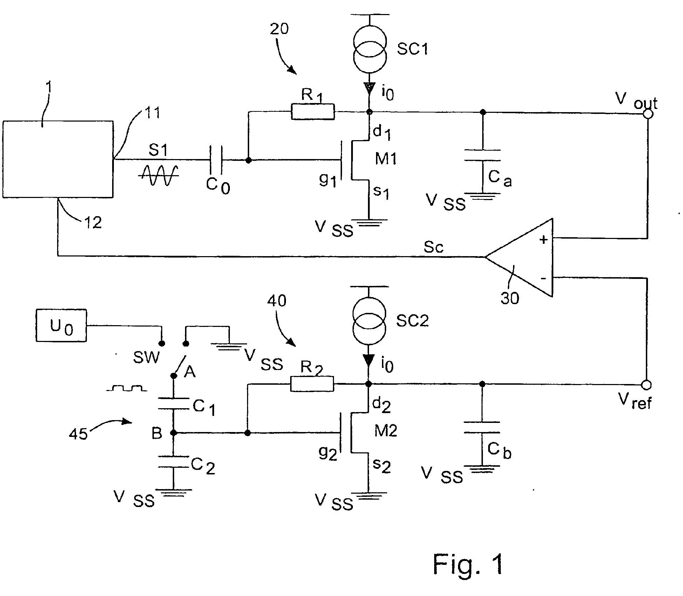

La figure 1 montre un schéma de principe d'un premier mode de réalisation de la présente invention employant des transistors MOS appariés fonctionnant en régime de faible inversion. Comme illustré à la figure 1, un dispositif électronique, indiqué par la référence numérique 1, délivre à une sortie 11 un signal de sortie alternatif S1, signal dont on désire asservir l'amplitude. Le dispositif électronique 1 peut par exemple être un circuit oscillateur, mais peut être constitué de tout autre dispositif électronique produisant un signal de sortie alternatif dont on désire asservir l'amplitude, tel un amplificateur de puissance.

Le signal de sortie S1 est appliqué sur une première branche, ou branche de mesure, repérée par la référence numérique 20, qui fournit en sortie une tension de mesure Vout représentative de l'amplitude du signal S1 à asservir. Ce signal de mesure Vout est comparé à une valeur de référence Vref au moyen d'un comparateur 30. Ce comparateur 30 fournit en réponse un signal de commande Sc qui est appliquée sur une borne d'asservissement 12 du dispositif électronique 1.

Comme mentionné en préambule, la branche de mesure 20 permettant de produire la tension de mesure Vout représentative de l'amplitude du signal de sortie S1 présente une sensibilité aux variations de température et de processus de fabrication. Afin de compenser et sensiblement annuler cette sensibilité de la branche de mesure 20, on produit, selon la présente invention, une tension de référence Vref présentant une sensibilité aux variations de température et de processus de fabrication qui est sensiblement égale à la sensibilité de la tension de mesure Vout.

A cet effet, on utilise, selon la présente invention, une seconde branche, ou branche de référence, appariée à la branche de mesure afin de produire la tension de référence Vref. Comme illustré schématiquement à la figure 1, la tension de référence Vref est produite par commutation d'une référence de tension U0, sensiblement stable en température, à l'entrée d'une branche de référence 40 appariée à la branche de mesure 20. La référence de tension U0 peut communément être une référence de "bandgap" ou tout autre référence de tension présentant une bonne stabilité en température.

La fréquence de commutation de la référence de tension U0 est dérivée de la fréquence du signal de sortie alternatif produit par le dispositif électronique, par exemple au moyen d'un chaîne de division.

Selon le premier mode de réalisation de l'invention illustré à la figure 1, les première et seconde branches appariées 20 et 40 emploient des transistors MOS polarisés de manière à fonctionner en régime de faible inversion. La branche de mesure 20 comprend ainsi un premier élément capacitif C0, un premier transistor MOS M1, une première source de courant SC1 délivrant un courant déterminé i0, un premier élément résistif R1 ainsi qu'un second élément capacitif Ca.

Plus spécifiquement, le premier élément capacitif C0, agissant comme capacité de couplage, est monté en série entre la sortie 11 du dispositif électronique 1 et une électrode de commande (grille g1) du transistor MOS M1. Ce dernier est monté en série avec la source de courant SC1, une électrode de courant (source s1) du transistor M1 étant connectée à un potentiel Vss, formant un potentiel de masse dans cet exemple, et l'autre électrode de courant (drain d1) est connectée à la source de courant SC1. L'élément résistif R1 est disposé entre l'électrode de commande g1 et l'électrode de courant d1 du transistor M1 afin d'assurer une polarisation adéquate de ce dernier. Le second élément capacitif Ca, agissant comme capacité de découplage, est quant à lui disposé en parallèle avec le transistor M1 entre son électrode de courant d1 et la masse Vss. La tension de mesure Vout représentative de l'amplitude du signal de sortie S1 est produite à l'électrode de courant d1 du transistor M1.

La seconde branche 40, appariée à la branche de mesure 20, comprend un diviseur capacitif 45 comprenant des troisième et quatrième éléments capacitifs C1, C2 montés en série entre une borne A et le potentiel de masse Vss, un second transistor MOS M2, une seconde source de courant SC2 délivrant également un courant i0, un second élément résistif R2 ainsi qu'un cinquième élément capacitif Cb. Plus particulièrement, une borne intermédiaire B du diviseur capacitif 45, à savoir le noeud de connexion entre les éléments capacitifs C1 et C2, est connectée à une électrode de commande (grille g2) du second transistor M2. Ce dernier est monté en série avec la seconde source de courant SC2. Une électrode de courant (source s2) du transistor M2 est connectée au potentiel Vss, et l'autre électrode de courant (drain d2) est connectée à la source de courant SC2. L'élément résistif R2 est également disposé entre l'électrode de commande g2 et l'électrode de courant d2 du transistor M2 afin d'assurer une polarisation adéquate de ce dernier. Le cinquième élément capacitif Cb, agissant comme capacité de découplage, est quant à lui disposé en parallèle avec le transistor M2 entre son électrode de courant d2 et la masse Vss. La tension de référence Vref est produite à l'électrode de courant d2 du transistor M2.

Les branches 20 et 40 étant appariées, on comprendra que les valeurs et/ou caractéristiques des éléments constitutifs de ces branches sont sensiblement égales. Ainsi les éléments résistifs R1, R2, les sources de courant SC1, SC2, ainsi que les transistors MOS M1 et M2 sont respectivement appariés. Les sources de courant SC1, SC2 sont par exemple produite par un montage "miroir de courant" (non illustré dans la figure) connu de l'homme du métier.

Selon l'invention, la tension de référence Vref est produite par commutation d'une référence de tension U0 à l'entrée de la seconde branche 40, indiquée par la borne A du diviseur capacitif 45 dans la figure 1. A cet effet, un commutateur SW est disposé entre la référence de tension U0 et la borne A du diviseur capacitif 45. Ce commutateur SW applique sélectivement la référence de tension U0 et le potentiel de masse Vss sur la borne A du diviseur capacitif 45. Ce commutateur SW peut être opéré à une fréquence moins élevée que la fréquence du signal alternatif S1 produit par le dispositif électronique 1. En conséquence, la consommation du système d'asservissement selon la présente invention peut être faible, rendant celle-ci parfaitement utilisable pour des applications à faible puissance, notamment dans le but d'être incorporé dans des dispositifs portatifs alimentés par batterie.

Comme déjà mentionné ci-dessus, la fréquence de commutation du commutateur SW est dérivée de la fréquence du signal de sortie alternatif du dispositif électronique 1. La fréquence de commutation du commutateur SW peut aisément être dérivée de la fréquence du signal de sortie alternatif du dispositif électronique au moyen d'une chaîne de division.

On comprendra que le rapport des valeurs des troisième et quatrième éléments capacitifs C1, C2 formant le diviseur capacitif 45 fixe le niveau de la tension de référence Vref. La valeur de ces éléments capacitifs C1, C2 est en outre choisie de sorte que leur somme (C1 + C2) est sensiblement égale à la valeur du premier élément capacitif C0 monté à l'entrée de la branche de mesure 20. Un tel choix a pour effet de rendre le système indépendant de la capacité de grille des transistors M1 et M2.

Selon l'invention, on comprendra donc que les sensibilités respectives des tensions de mesure Vout et de référence Vref vis-à-vis des variations de température et de processus de fabrication sont rendues sensiblement égale par l'emploi de branches 20, 40 appariées pour produire ces tensions. Il résulte de cet agencement que le signal de commande Sc produit en sortie du comparateur 30 est sensiblement indépendant de ces variations et que l'amplitude du signal de sortie S1 est en conséquence asservie à une valeur sensiblement indépendante de ces variations.

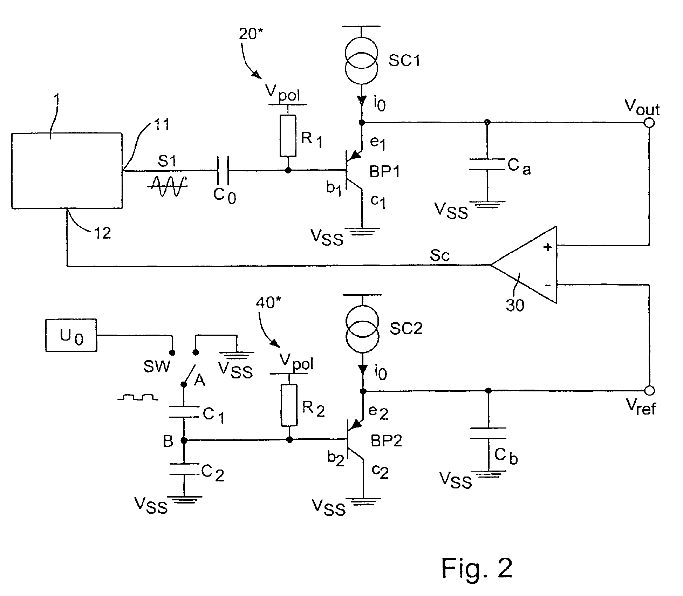

La figure 2 montre un schéma de principe d'un second mode de réalisation de la présente invention employant des transistors bipolaires appariés. De manière analogue au schéma de principe de la figure 1, le dispositif électronique 1 délivre son signal de sortie alternatif S1 à l'entrée d'une branche de mesure, indiquée par la référence 20*, et la tension de référence Vref est produite par commutation d'une référence de tension U0 à l'entrée d'une branche de référence, indiquée par la référence numérique 40*, appariée à la branche de mesure 20*. Un comparateur 30 permet de produire un signal de commande Sc en réponse à la comparaison des tensions de mesure Vout et de référence Vref qui est appliqué sur une borne d'asservissement 12 du dispositif électronique 1. Dans cet exemple, toutefois, les branches 20* et 40* diffèrent notamment en ce qu'elles comportent chacune un transistor bipolaire.

Selon ce second mode de réalisation de l'invention illustré à la figure 2, la branche de mesure 20* comprend ainsi un premier élément capacitif C0, un premier transistor bipolaire pnp BP1, une première source de courant SC1 délivrant un courant déterminé i0, un premier élément résistif R1 ainsi qu'un second élément capacitif Ca. Plus spécifiquement, le premier élément capacitif C0, agissant comme capacité de couplage, est monté en série entre la sortie 11 du dispositif électronique 1 et une électrode de commande (base b1) du transistor bipolaire BP1. Ce dernier est monté en série avec la source de courant SC1. Une électrode de courant (collecteur c1) du transistor BP1 est connectée au potentiel de masse Vss, et l'autre électrode de courant (émetteur e1) est connectée à la source de courant SC1. L'élément résistif R1 est disposé entre l'électrode de commande b1 du transistor BP1 et un potentiel de polarisation Vpol afin d'assurer une polarisation adéquate du transistor. Le second élément capacitif Ca, agissant comme capacité de découplage, est quant à lui disposé en parallèle avec le transistor BP1 entre son électrode de courant e1 et la masse Vss. La tension de mesure Vout représentative de l'amplitude du signal de sortie S1 est produite à l'électrode de courant e1 du transistor bipolaire BP1.

De même, la branche de référence 40*, appariée à la branche de mesure 20*, comprend un diviseur capacitif 45 comprenant des troisième et quatrième éléments capacitifs C1, C2 montés en série entre une borne A et le potentiel de masse Vss, un second transistor bipolaire pnp BP2, une seconde source de courant SC2 délivrant également un courant i0, un second élément résistif R2 ainsi qu'un cinquième élément capacitif Cb. Plus particulièrement, une borne intermédiaire B du diviseur capacitif 45, à savoir le noeud de connexion entre les éléments capacitifs C1 et C2, est connectée à une électrode de commande (base b2) du second transistor bipolaire BP2. Ce dernier est monté en série avec la seconde source de courant SC2. Une électrode de courant (collecteur c2) du transistor BP2 est connectée au potentiel de masse Vss, et l'autre électrode de courant (émetteur e2) est connectée à la source de courant SC2. L'élément résistif R2 est également disposé entre l'électrode de commande b2 du transistor BP2 et le potentiel de polarisation Vpol afin d'assurer une polarisation adéquate du transistor. Le cinquième élément capacitif Cb, agissant comme capacité de découplage, est quant à lui disposé en parallèle avec le transistor BP2 entre son électrode de courant e2 et la masse Vss. La tension de référence Vref est produite à l'électrode de courant e2 du transistor bipolaire BP2.

Au même titre que le mode de réalisation de la figure 1, les branches 20* et 40* étant appariées, on comprendra que les valeurs et/ou caractéristiques des éléments constitutifs de ces branches sont sensiblement égales. Ainsi les éléments résistifs R1, R2, les sources de courant SC1, SC2, ainsi que les transistors bipolaires BP1 et BP2 sont respectivement appariés.

Selon ce second mode de réalisation, la tension de référence Vref est produite, de manière analogue au premier mode de réalisation, par commutation d'une référence de tension U0 à l'entrée de la branche de référence 40*, indiquée par la borne A du diviseur capacitif 45 dans la figure 2. Un commutateur SW est ainsi disposé entre la référence de tension U0 et la borne A du diviseur capacitif 45, et applique, de même, sélectivement la référence de tension U0 et le potentiel de masse Vss sur la borne A du diviseur capacitif 45.

On comprendra en outre que le rapport des valeurs des troisième et quatrième éléments capacitifs C1, C2 formant le diviseur capacitif 45 fixe le niveau de la tension de référence Vref. La valeur de ces éléments capacitifs C1, C2 est également choisie de sorte que leur somme (C1 + C2) est sensiblement égale à la valeur du premier élément capacitif C0 monté à l'entrée de la branche de mesure 20*.

Ce second mode de réalisation constitue une alternative au premier mode de réalisation permettant de produire un signal de commande Sc en sortie du comparateur 30 ne présentant sensiblement aucune sensibilité aux variations de température et de processus de fabrication. On notera de plus que le second mode de réalisation offre avantageusement la possibilité d'utiliser des transistors bipolaires verticaux non caractérisés, structures parasites qui sont typiquement disponibles sur des circuits intégrés.

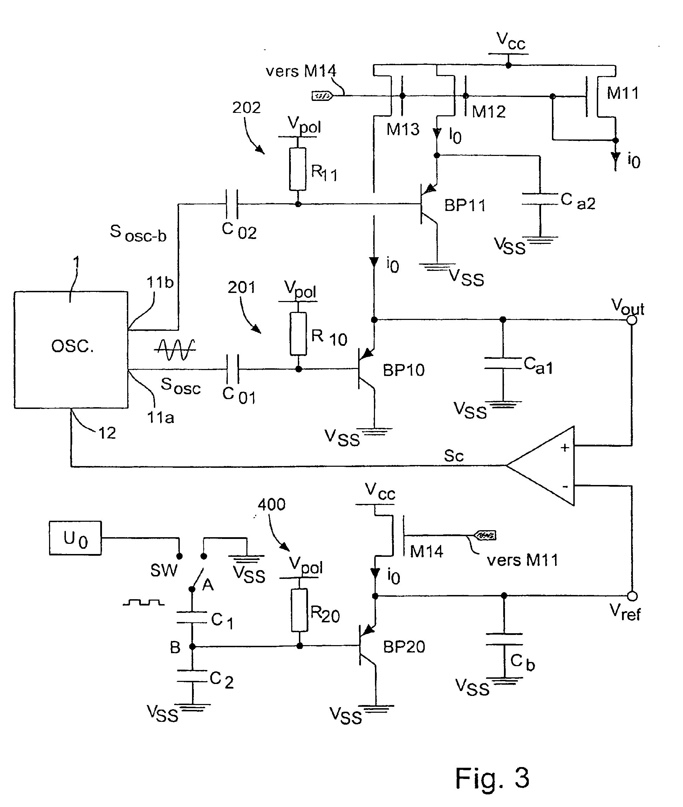

Au décrira maintenant au moyen de la figure 3, un exemple particulier de réalisation de la présente invention faisant appel au principe illustré à la figure 2, à savoir le principe faisant appel à des transistors bipolaires appariés. Comme mentionné plus haut, ces transistors bipolaires peuvent avantageusement être des transistors bipolaires verticaux non caractérisés typiquement présents sur le circuit.

Le dispositif électronique 1 est ici constitué d'un circuit oscillateur délivrant un signal d'oscillation Sosc de fréquence déterminée. A titre d'illustration, le circuit oscillateur 1 est alimenté par une tension d'alimentation de l'ordre de 1.2 V et la fréquence du signal d'oscillation produit par le circuit oscillateur 1 est de l'ordre de 434 MHz dans cet exemple. Plus spécifiquement, le circuit oscillateur 1, dont la structure n'est pas détaillée ici car connue de l'homme du métier, comporte des première et seconde sorties 11a et 11b délivrant respectivement le signal d'oscillation Sosc et un signal d'oscillation Sosc_b, déphasé de 180° par rapport au signal d'oscillation Sosc. Le circuit oscillateur 1 comporte également une borne d'asservissement 12 permettant d'agir sur l'amplitude du signal de sortie Sosc (respectivement Sosc_b).

Afin de produire la tension de mesure Vout représentative de l'amplitude du signal de sortie, une branche de mesure du type illustré à la figure 2 est connectée en sortie du circuit oscillateur 1. Plus spécifiquement, deux branches de mesure identiques 201 et 202 sont respectivement connectées aux bornes de sortie 11a et 11b du circuit oscillateur 1. Deux branches de mesures sont utilisées ici afin de charger symétriquement les sorties de l'oscillateur. Toutefois, seule la sortie d'une des branches, ici la branche de mesure 201, n'est nécessaire pour produire le signal d'asservissement (Sc) de l'oscillateur.

Afin de produire la tension de référence Vref, une branche de référence 400 appariées aux branches de mesures 201 et 202 est utilisée selon le principe décrit en référence à la figure 2. Ainsi une référence de tension U0 est commutée à une entrée A de la seconde branche 400 au moyen d'un commutateur SW de sorte que la tension U0 et le potentiel de masse Vss est sélectivement appliqué à l'entrée de la seconde branche 400. A titre d'illustration, la fréquence de commutation du commutateur SW est de l'ordre de 12.5 MHz dans cet exemple. Cette fréquence est avantageusement dérivée de la fréquence du signal d'oscillation Sosc au moyen d'une chaîne de division (non représentée). Les valeurs des éléments capacitifs C1 et C2 formant le diviseur capacitif de la branche de référence 400 sont respectivement choisies à 0.1 pF et 0.2 pF.

Conformément au principe décrit en référence à la figure 2, les branches 201, 202 et 400 comportent chacune un transistor bipolaire BP10, BP11, BP20, respectivement. Un montage de type miroir de courant formé de quatre transistors MOS M11, M12, M13 et M14 assurent qu'un courant continu i0 traverse les branches comprenant les transistors bipolaires BP10, BP11 et BP20. Le courant i0 est ici de l'ordre de 1 µA.

La polarisation des transistors bipolaires BP10, BP11 et BP20 est assurée par des éléments résistifs R10, R11 et R20 connectés respectivement entre les électrodes de commande (bases) des transistors bipolaires et un potentiel de polarisation Vpol. A titre d'illustration les éléments résistifs R10, R11 et R20 ont des valeurs de l'ordre de 100 kΩ dans cet exemple et le potentiel de polarisation Vpol est choisi à 0.2 V. La valeur des capacités de couplages C01 et C02 montées respectivement aux entrées des branches de mesure 201 et 202 est, dans cet exemple, de l'ordre de 0.3 pF à la fréquence de 434 MHz du signal d'oscillation. La valeur des capacités de découplage Ca1 et Ca2 montées respectivement en sortie des branches de mesure 201 et 202 est de l'ordre de 1 pF et la capacité de découplage Cb montée en sortie de la branche de référence 400 est de l'ordre de 10 pF.

Comme illustré à la figure 3, la tension de mesure Vout produite en sortie de la branche de mesure 201 est ainsi appliquée sur une borne non inverseuse du comparateur 300 et la tension de référence Vref produite en sortie de la branche de référence 400 est appliquée sur une borne inverseuse du comparateur 300, ce dernier produisant en réponse le signal de commande Sc qui est appliqué sur la borne d'asservissement 12 du circuit oscillateur 1.

On notera que les exemples numériques indiqués plus haut ne le sont qu'à titre illustratif uniquement. Le dimensionnement des composants constitutifs des branches de mesure et de référence devra bien évidemment être adapté à l'application désirée. Dans le cas d'un circuit oscillateur tel qu'illustré à la figure 3, le dimensionnement des composants dépend ainsi notamment de la fréquence du signal d'oscillation délivré par le circuit oscillateur ainsi que la fréquence de commutation du commutateur dans la branche de référence. L'homme du métier sera parfaitement capable d'effectuer ce dimensionnement selon l'application désirée.

Etant donné que la fréquence de commutation de la référence de tension est dérivée directement de la fréquence du signal de sortie alternatif du dispositif électronique, il conviendra préférablement de munir le dispositif de moyens additionnels pour assurer un démarrage adéquat du dispositif. En effet, si le dispositif électronique est inactif, c'est-à-dire si aucun signal alternatif n'est délivré en sortie du dispositif, la fréquence de construction de la tension de référence est également nulle. Dans ces conditions, les signaux de mesure Vout et de référence Vref ont des valeurs sensiblement équivalentes et le signal d'asservissement produit en sortie des moyens de comparaison maintient le dispositif électronique dans son état, empêchant le démarrage du dispositif.

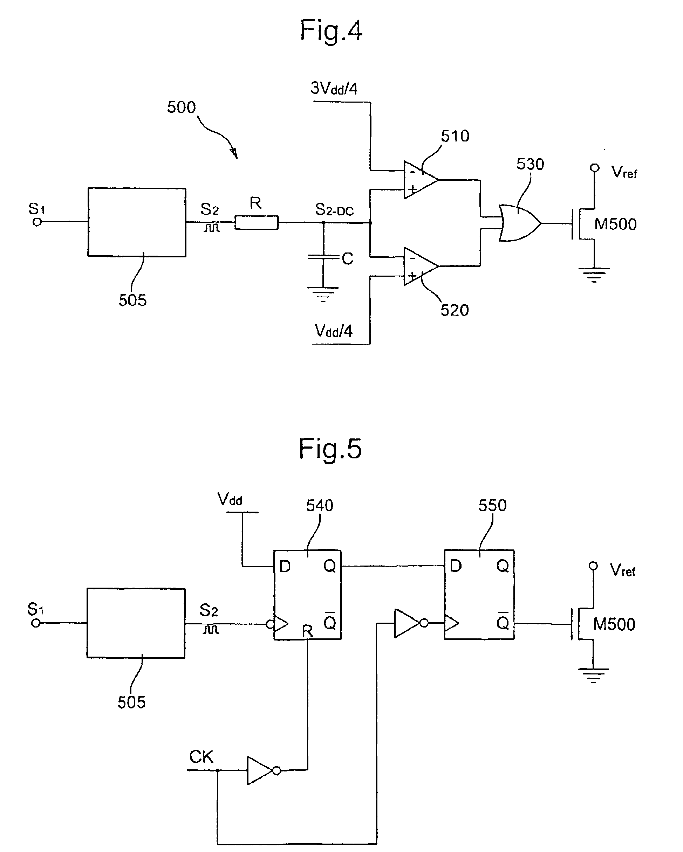

Au moyen des figures 4 et 5, on décrira maintenant deux exemples de réalisation de moyens de détection d'oscillation pour détecter l'activité du dispositif électronique et pour agir sur le signal d'asservissement afin de permettre un démarrage du dispositif électronique dans l'éventualité où le dispositif électronique ne délivre pas de signal de sortie alternatif. Plus spécifiquement, ces moyens de détection d'oscillation comprennent des moyens pour amener la tension de référence produite par la branche de référence à une valeur déterminée différente de la tension de mesure (par exemple à la masse Vss) dans l'éventualité où le dispositif électronique ne délivre pas de signal de sortie alternatif.

La figure 4 illustre ainsi un premier exemple de réalisation, sous forme analogique, de moyens de détection d'oscillation désignés globalement par la référence numérique 500. Ces moyens 500 reçoivent en entrée un signal alternatif S2 sensiblement égal ou dérivé du signal de sortie alternatif S1 du dispositif électronique 1. Le signal alternatif S2 est préférablement un signal à relativement basse fréquence et peut typiquement être dérivé du signal de sortie alternatif S1 après division (par exemple au moyen d'un étage de division 505 comme schématisé dans la figure). On admettra dans la suite de la description de ce mode de réalisation que ce signal alternatif S2 oscille entre des niveaux de tensions Vss et Vdd. Les moyens 500 sont connectés en sortie sur le terminal où est délivrée la tension de référence Vref, à savoir la borne inverseuse du comparateur 30 dans les illustrations des figures 1 à 3.

Plus spécifiquement, les moyens de détection d'oscillation 500 comprennent en entrée un agencement d'un élément résistif R et d'un élément capacitif C pour extraire la valeur moyenne, désigné S2-DC, du signal alternatif S2. Cette valeur moyenne S2-DC est appliquée sur les entrées de deux comparateurs 510, 520 agencés respectivement pour comparer la valeur moyenne du signal alternatif S2 avec des seuils haut et bas déterminés, choisis dans cet exemple à 3/4 Vdd et 1/4 Vdd. Deux comparateurs sont prévus dans l'exemple illustré, car le signal S2, qui est fournit en sortie de l'étage de division 505, peut prendre une valeur basse (sensiblement égale à Vss) ou haute (sensiblement égale à Vdd) à l'état inactif. L'utilisation d'un unique comparateur pourrait être envisagée pour autant que le signal S2 ait une unique valeur déterminée à l'état inactif.

Dans l'exemple de la figure 4, chaque comparateur 510, 520 fournit en sortie un signal indiquant si la valeur moyenne S2-DC du signal d'entrée S2 est supérieure au seuil haut, respectivement si cette valeur moyenne est inférieure au seuil bas défini ci-dessus. Les deux sorties des comparateurs 510, 520 sont connectées sur une porte OU 530 dont la sortie commande la grille d'un transistor MOS M500 branché par ses électrodes de courant entre la tension de référence Vref et la masse Vss dans cet exemple.

Ainsi, dans l'éventualité où le dispositif électronique est inactif (signal S2 à Vss ou à Vdd), le transistor M500 est commandé pour amener la tension de référence Vref à la masse. En se référant aux exemples des figures 1 à 3, on notera que la tension de mesure Vout produite en sortie de la branche de mesure est inversement proportionnelle à l'amplitude du signal de sortie alternatif S1 et est notamment maximale pour une amplitude nulle du signal de sortie S1. En forçant la tension de référence Vref à la masse (c'est-à-dire une tension différente de la tension de mesure Vout) conformément à ce qui a été décrit ci-dessus, le dispositif électronique peut ainsi démarrer.

La figure 5 illustre une second exemple de réalisation des moyens de détection d'oscillation 500 constituant une alternative à la réalisation de la figure 4. A la différence de l'exemple de la figure 4, cette alternative est réalisée sous forme digitale et comprend deux bascules bistables D, repérées par les références numériques 540 et 550. La première bascule 540 est cadencée par la fréquence du signal alternatif S2 (par exemple un signal à relativement basse fréquence dérivé du signal de sortie alternatif S1 comme précédemment) et son entrée D est fixée à un niveau logique haut (Vdd). La sortie non-inversée de la bascule 540 est connectée à l'entrée D de la seconde bascule 550. La sortie inversée de cette seconde bascule 550 est reliée à la grille du transistor M500. Un signal d'horloge CK ayant une fréquence inférieure à la fréquence du signal d'entrée S2 est utilisé pour la mise à zéro de la première bascule 540 et pour le cadencement de la seconde bascule 550. Ce signal d'horloge CK n'est pas dérivé du signal de sortie alternatif S1 du dispositif électronique mais doit être dérivé d'une autre référence.

Dans l'exemple de la figure 5, si le dispositif électronique est inactif, la première bascule 540 n'est plus cadencée par un signal d'horloge et sa sortie passe au niveau logique bas, provoquant, suite à une impulsion d'horloge du signal CK, le passage au niveau logique haut de la sortie inversée de la bascule 550 commandant le transistor M500. La tension de référence Vref est ainsi à nouveau amenée à la masse Vss pour permettre le démarrage du dispositif électronique.

On comprendra que diverses modifications et/ou améliorations évidentes pour l'homme du métier peuvent être apportées au dispositif électronique asservi en amplitude décrit dans la présente description sans sortir du cadre de l'invention défini par les revendications annexées.

## Revendications

1. Dispositif électronique (1) asservi en amplitude destiné à produire à une sortie (11; 11a) un signal de sortie alternatif (S1; Sosc) d'amplitude sensiblement constante, ce dispositif électronique comprenant :
- une branche de mesure (20; 20*; 201) destinée à produire une tension de mesure (Vout) représentative de l'amplitude dudit signal de sortie (S1; Sosc);
- une branche de référence (40; 40*; 400) pour produire une tension de référence (Vref), cette branche de référence étant appariée à ladite branche de mesure (20; 20*; 201) de sorte que la tension de référence (Vref) présente une sensibilité aux variations de température et de processus de fabrication qui est sensiblement égale à la sensibilité de ladite tension de mesure (Vout); et
- un comparateur (30; 300) agencé pour comparer ladite tension de mesure (Vout) avec ladite tension de référence (Vref) et produire en réponse un signal d'asservissement (Sc) qui est appliqué sur une borne d'asservissement (12) dudit dispositif électronique (1) afin d'asservir l'amplitude dudit signal de sortie (S1; Sosc);
**caractérisé en ce qu'**une référence de tension (U0) est sélectivement commutée à une fréquence de commutation, qui est dérivée de la fréquence du signal de sortie alternatif (S1; Sosc), à une entrée (A) de ladite branche de référence (40; 40*; 400) afin de produire ladite tension de référence (Vref).

2. Dispositif électronique selon la revendication 1, **caractérisé en ce que** ladite branche de mesure (20) comprend :
- un premier transistor MOS (M1) comprenant une électrode de commande (g1) et des première et seconde électrodes de courant (d1, s1);
- un premier élément capacitif (C0) monté en série entre la sortie (11; 11a) du dispositif électronique et l'électrode de commande du premier transistor (M1);
- une première source de courant (SC1) montée en série avec ledit premier transistor (M1) et produisant un courant (i0) sensiblement constant;
- un premier élément résistif (R1) monté entre la première électrode de courant (d1) et l'électrode de commande (g1) dudit premier transistor (M1); et
- un second élément capacitif (Ca) monté en parallèle avec ledit premier transistor (M1) entre ses première et seconde électrodes de courant (d1, s1);
ladite tension de mesure (Vout) étant produite à ladite première électrode de courant (d1) du premier transistor (M1);
le dispositif électronique étant en outre **caractérisé en ce que** ladite branche de référence (40) comprend :
- un second transistor MOS (M2) apparié au dit premier transistor (M1) et comprenant une électrode de commande (g2) et des première et seconde électrodes de courant (d2, s2);
- un diviseur capacitif (45) comprenant des troisième et quatrième éléments capacitifs (C1, C2) montés en série entre une borne d'entrée (A) et un potentiel de référence (Vss), et un moyen de commutation (SW) agencé pour appliquer sélectivement ladite référence de tension (U0) et ledit potentiel de référence (Vss) à ladite borne d'entrée (A) dudit diviseur capacitif (45), une borne intermédiaire (B) dudit diviseur capacitif (45) étant connectée à l'électrode de commande (g2) dudit second transistor (M2);
- une seconde source de courant (SC2) montée en série avec ledit second transistor (M2) et produisant également ledit courant (i0) sensiblement constant;
- un second élément résistif (R2) de valeur sensiblement égale au dit premier élément résistif (R1) monté entre la première électrode de courant (d2) et l'électrode de commande (g2) dudit second transistor (M2); et
- un cinquième élément capacitif (Cb) monté en parallèle avec ledit second transistor (M2) entre ses première et secondes électrodes de courant (d2, s2);
ladite tension de référence (Vref) étant produite à ladite première électrode de courant (d2) du second transistor (M2).

3. Dispositif électronique selon la revendication 1, **caractérisé en ce que** ladite branche de mesure (20*; 201) comprend :
- un premier transistor bipolaire (BP1; BP10) comprenant une électrode de commande (b1) et des première et seconde électrodes de courant (e1, c1);
- un premier élément capacitif (C0; C01) monté en série entre la sortie (11; 11 a) du dispositif électronique et l'électrode de commande (b1) du premier transistor (BP1; BP10);
- une première source de courant (SC1) montée en série avec ledit premier transistor (BP1; BP10) et produisant un courant (i0) sensiblement constant;
- un premier élément résistif (R1; R10) monté entre la première électrode de commande (b1) dudit premier transistor (BP1; BP10) et un potentiel de polarisation (Vpol); et
- un second élément capacitif (Ca; Ca1) monté en parallèle avec ledit premier transistor (BP1; BP10) entre ses première et seconde électrodes de courant (e1, c1);
ladite tension de mesure (Vout) étant produite à ladite première électrode de courant (e1) du premier transistor (BP1; BP10);
le dispositif électronique étant en outre **caractérisé en ce que** ladite branche de référence (40*; 400) comprend :
- un second transistor bipolaire (BP2; BP20) apparié au dit premier transistor (BP1; BP10) et comprenant une électrode de commande (b2) et des première et seconde électrodes de courant (e2, c2);
- un diviseur capacitif (45) comprenant des troisième et quatrième éléments capacitifs (C1, C2) montés en série entre une borne entrée (A) et un potentiel de référence (Vss) et un moyen de commutation (SW) agencé pour appliquer sélectivement ladite référence de tension (U0) et ledit potentiel de référence (Vss) à ladite borne d'entrée (A) dudit diviseur capacitif (45), une borne intermédiaire (B) dudit diviseur capacitif (45) étant connectée à l'électrode de commande (b2) dudit second transistor (BP2; BP20);
- une seconde source de courant (SC2) montée en série avec ledit second transistor (BP2; BP20) et produisant également ledit courant (i0) sensiblement constant;
- un second élément résistif (R2; R20) de valeur sensiblement égale au dit premier élément résistif (R1; R10) monté entre l'électrode de commande (b2) dudit second transistor (BP2; BP20) et ledit potentiel de polarisation (Vpol); et
- un cinquième élément capacitif (Cb) monté en parallèle avec ledit second transistor (BP2; BP20) entre ses première et secondes électrodes de courant (e2, c2);
ladite tension de référence (Vref) étant produite à ladite première électrode de courant (e2) du second transistor (BP2; BP20).

4. Dispositif électronique selon la revendication 3, **caractérisé en ce que** lesdits transistors bipolaires (BP1, BP2; BP10, BP20) sont des transistors bipolaires verticaux non caractérisés**.**

5. Dispositif électronique selon la revendication 2 ou 3, **caractérisé en ce que** la somme des valeurs de capacité desdits troisième et quatrième éléments capacitifs (C1, C2) est sensiblement égale à la valeur de capacité dudit premier élément capacitif (C0; C01).

6. Dispositif électronique selon l'une quelconque des revendications précédentes, **caractérisé en ce que** le dispositif électronique est un circuit oscillateur comportant des premières et secondes sorties (11a, 11b) produisant respectivement un premier signal d'oscillation (Sosc) qui est appliqué sur ladite branche de mesure (201) et un second signal d'oscillation (Sosc_b), déphasé de 180° par rapport au premier signal d'oscillation, qui est appliqué sur une seconde branche (202) appariée à ladite branche de mesure (201) afin de charger de manière symétrique lesdites premières et secondes sorties (11a, 11b) du circuit oscillateur.

7. Dispositif électronique selon la revendication 1, **caractérisé en ce qu'**il comporte en outre des moyens de détection d'oscillation (500) pour détecter l'activité dudit dispositif électronique et, dans l'éventualité où ledit dispositif électronique ne délivre pas de signal de sortie alternatif (S1; Sosc), pour agir sur ledit signal d'asservissement (Sc) afin de permettre un démarrage dudit dispositif électronique.

8. Dispositif électronique selon la revendication 7, **caractérisé en ce que** lesdits moyens de détection d'oscillation (500) comprennent des moyens (M500) pour amener ladite tension de référence (Vref) à une valeur déterminée (Vss) différente de la valeur de ladite tension de mesure (Vout) dans l'éventualité où ledit dispositif électronique ne délivre pas de signal de sortie alternatif (S1; Sosc).

## Patentansprüche

1. Amplitudengeregelte elektronische Vorrichtung (1), die dazu bestimmt ist, an einem Ausgang (11; 11a) ein Ausgangswechselsignal (S1; Sosc) mit im Wesentlichen konstanter Amplitude zu erzeugen, wobei diese elektronische Vorrichtung umfasst:
- einen Messzweig (20; 20*; 210), der dazu vorgesehen ist, eine Messspannung (Vout) zu erzeugen, die die Amplitude des Ausgangssignals (S1; Sosc) darstellt;
- einen Referenzzweig (40; 40*, 400), um eine Referenzspannung (Vref) zu erzeugen, wobei dieser Referenzzweig mit dem Messzweig (20; 20*; 201) in der Weise gepaart ist, dass die Referenzspannung (Vref) gegenüber Temperatur-und Fertigungsprozess-Schwankungen eine Empfindlichkeit zeigt, die im Wesentlichen gleich der Empfindlichkeit der Messspannung (Vout) ist; und
- einen Komparator (30; 300), der so beschaffen ist, dass er die Messspannung (Vout) mit der Referenzspannung (Vref) vergleicht und in Reaktion darauf ein Regelungssignal (Sc) erzeugt, das an einen Regelungsanschluss (12) der elektronischen Vorrichtung (1) angelegt wird, um die Amplitude des Ausgangssignals (S1; Sosc) zu regeln;
**dadurch gekennzeichnet, dass** eine Spannungsreferenz (U0) wahlweise mit einer Umschaltfrequenz, die von der Frequenz des Ausgangs-Wechselsignals (S1; Sosc) abgeleitet ist, zu einem Eingang (A) des Referenzzweigs (40; 40*; 400) umgeschaltet wird, um die Referenzspannung (Vref) zu erzeugen.

2. Elektronische Vorrichtung nach Anspruch 1, **dadurch gekennzeichnet, dass** der Messzweig (20) umfasst:
- einen ersten MOS-Transistor (M1), der eine Steuerelektrode (g1) und eine erste und eine zweite Stromelektrode (d1, s1) umfasst;
- ein erstes kapazitives Element (C0), das mit dem Ausgang (11; 11a) der elektronischen Vorrichtung und der Steuerelektrode des ersten Transistors (M1) in Reihe geschaltet ist;
- eine erste Stromquelle (Sc1), die mit dem ersten Transistor (M1) in Reihe geschaltet ist und einen im Wesentlichen konstanten Strom (i0) erzeugt;
- ein erstes resistives Element (R1), das zwischen die erste Stromelektrode (d1) und die Steuerelektrode (g1) des ersten Transistors (M1) geschaltet ist; und
- ein zweites kapazitives Element (Ca), das zu dem ersten Transistor (M1) zwischen der ersten und der zweiten Stromelektrode (d1, s1) parallelgeschaltet ist;
wobei die Messspannung (Vout) bei der ersten Stromelektrode (d1) des ersten Transistors (M1) erzeugt wird;
wobei die elektronische Vorrichtung außerdem **dadurch gekennzeichnet ist, dass** der Referenzzweig (40) umfasst:
- einen zweiten MOS-Transistor (M2), der mit dem ersten Transistor (M1) gepaart ist und eine Steuerelektrode (g2) und eine erste und eine zweite Stromelektrode (d2, s2) umfasst;
- einen kapazitiven Teiler (45), der ein drittes und ein viertes kapazitives Element (C1, C2), die zwischen den Eingangsanschluss (A) und ein Referenzpotential (Vss) in Reihe geschaltet sind, und ein Umschaltmittel (SW), das so beschaffen ist, dass es die Referenzspannung (U0) und das Referenzpotential (Vss) wahlweise an den Eingangsanschluss (A) des kapazitiven Teilers (45) anlegt, umfasst, wobei ein Zwischenanschluss (B) des kapazitiven Teilers (45) mit der Steuerelektrode (g2) des zweiten Transistors (M2) verbunden ist;
- eine zweite Stromquelle (Sc2), die mit dem zweiten Transistor (M2) in Reihe geschaltet ist und ebenfalls den im Wesentlichen konstanten Strom (i0) erzeugt;
- ein zweites resistives Element (R2), das einen Wert besitzt, der im Wesentlichen gleich jenem des ersten resistiven Elements (R1) ist, und das zwischen die erste Stromelektrode (d2) und die Steuerelektrode (g2) des zweiten Transistors (M2) geschaltet ist; und
- ein fünftes kapazitives Element (Cb), das zu dem zweiten Transistor (M2) zwischen seiner ersten und seiner zweiten Stromelektrode (d2, s2) parallelgeschaltet ist;
wobei die Referenzspannung (Vref) bei der ersten Stromelektrode (d2) des zweiten Transistors (M2) erzeugt wird.

3. Elektronische Vorrichtung nach Anspruch 1, **dadurch gekennzeichnet, dass** der Messzweig (20*; 201) umfasst:
- einen ersten Bipolartransistor (BP1; BP10), der eine Steuerelektrode (b1) und eine erste und eine zweite Stromelektrode (e1, c1) umfasst;
- ein erstes kapazitives Element (C0, C01), das zwischen den Ausgang (11; 11a) der elektronischen Vorrichtung und die Steuerelektrode (b1) des ersten Transistors (BP1; BP10) in Reihe geschaltet ist;
- eine erste Stromquelle (Sc1), die mit dem ersten Transistor (BP1; BP10) in Reihe geschaltet ist und einen im Wesentlichen konstanten Strom (i0) erzeugt;
- ein erstes resistives Element (R1; R10), das zwischen die erste Steuerelektrode (b1) des ersten Transistors (BP1; BP10) und ein Polarisationspotential (Vpol) geschaltet ist; und
- ein zweites kapazitives Element (Ca; Ca1), das zu dem ersten Transistor (BP1; BP10) zwischen seiner ersten Stromelektrode und seiner zweiten Stromelektrode (e1, c1) parallelgeschaltet ist;
wobei die Messspannung (Vout) an der ersten Stromelektrode (e1) des ersten Transistors (BP1; BP10) erzeugt wird;
wobei die elektronische Vorrichtung außerdem **dadurch gekennzeichnet ist, dass** der Referenzzweig (40*; 400) umfasst:
- einen zweiten Bipolartransistor (BP2; BP20), der mit dem ersten Transistor (BP1; BP10) gepaart ist und eine Steuerelektrode (b2) und eine erste und eine zweite Stromelektrode (e2, c2) umfasst;
- einen kapazitiven Teiler (45), der ein drittes und ein viertes kapazitives Element (C1, C2), die zwischen einen Eingangsanschluss (A) und ein Referenzpotential (Vss) in Reihe geschaltet sind, sowie ein Umschaltmittel (SW), das so beschaffen ist, dass es wahlweise die Referenzspannung (U0) und das Referenzpotential (Vss) an den Eingangsanschluss (A) des kapazitiven Teilers (45) anlegt, umfasst, wobei ein Zwischenanschluss (B) des kapazitiven Teilers (45) mit der Steuerelektrode (b2) des zweiten Transistors (BP2; BP20) verbunden ist;
- eine zweite Stromquelle (Sc2), die mit dem zweiten Transistor (BP2; BP20) in Reihe geschaltet ist und ebenfalls den im Wesentlichen konstanten Strom (i0) erzeugt;
- ein zweites resistives Element (R2; R20), das einen Wert besitzt, der im Wesentlichen gleichen jenem des ersten resistiven Elements (R1; R10) ist, und das zwischen die Steuerelektrode (b2) des zweiten Transistors (BP2; BP20) und das Polarisationspotential (Vpol) geschaltet ist; und
- ein fünftes kapazitives Element (Cb), das zu dem zweiten Transistor (BP2; BP20) zwischen seiner ersten Stromelektrode und seiner zweiten Stromelektrode (e2, c2) parallelgeschaltet ist;
wobei die Referenzspannung (Vref) bei der ersten Stromelektrode (e2) des zweiten Transistors (BP2; BP20) erzeugt wird.

4. Elektronische Vorrichtung nach Anspruch 3, **dadurch gekennzeichnet, dass** die Bipolartransistoren (BP1, BP2; BP10, BP20) nicht bezeichnete vertikale Bipolartransistoren sind.

5. Elektronische Vorrichtung nach Anspruch 2 oder 3, **dadurch gekennzeichnet, dass** die Summe der Kapazitätswerte des dritten und des vierten kapazitiven Elements (C1, C2) im Wesentlichen gleich dem Kapazitätswert des ersten kapazitiven Elements (C0; C01) ist.

6. Elektronische Vorrichtung nach einem der vorhergehenden Ansprüche, **dadurch gekennzeichnet, dass** die elektronische Vorrichtung eine Oszillatorschaltung ist, die einen ersten und einen zweiten Ausgang (11a, 11b) aufweist, die ein erstes Oszillationssignal (Sosc), das an den Messzweig (201) angelegt wird, bzw. ein zweites Oszillationssignal (Sosc_b), das zu dem ersten Oszillationssignal um 180° phasenverschoben ist und das an einen mit dem Messzweig (201) gepaarten zweiten Zweig (202) angelegt wird, erzeugen, um den ersten bzw. den zweiten Ausgang (11a, 11b) der Oszillatorschaltung symmetrisch zu belasten.

7. Elektronische Vorrichtung nach Anspruch 1, **dadurch gekennzeichnet, dass** sie außerdem Oszillationserfassungsmittel (500) umfasst, um die Aktivität der elektronischen Vorrichtung zu erfassen und in dem Fall, in dem die elektronische Vorrichtung kein Ausgangs-Wechselsignal (S1; Sosc) liefert, auf das Regelungssignal (Sc) einzuwirken, um ein Hochfahren der elektronischen Vorrichtung zu ermöglichen.

8. Elektronische Vorrichtung nach Anspruch 7, **dadurch gekennzeichnet, dass** die Oszillationserfassungsmittel (500) Mittel (M500) umfassen, um die Referenzspannung (Vref) auf einen bestimmten Wert (Vss) zu führen, der von dem Wert der Messspannung (Vout) verschieden ist, falls die elektronische Vorrichtung das Ausgangs-Wechselsignal (S1; Sosc) nicht liefert.

## Claims

1. Amplitude-controlled electronic device (1) for generating at an output (11; 11a) an alternating output signal (S1; Sosc) of substantially constant amplitude, said electronic device including:
- a measuring branch (20; 20*; 201) for generating a measuring voltage (Vout) representative of the amplitude of said output signal (S1; Sosc);
- a reference branch (40; 40*; 400) for generating a reference voltage (Vref), this reference branch being matched with said measuring branch (20; 20*; 201) so that the reference voltage (Vref) has a sensitivity to temperature and manufacturing process variations which is substantially equal to the sensitivity of said measuring voltage (Vout); and
- a comparator (30; 300) for comparing said measuring voltage (Vout) with said reference voltage (Vref) and generating in response a control signal (Sc) which is applied on a control terminal (12) of said electronic device (1) in order to control the amplitude of said output signal (S1; Sosc);
**characterised in that** a voltage reference (U0) is selectively switched at a switching frequency, which is derived from the frequency of said alternating output signal (S1; Sosc), at an input (A) of said reference branch (40; 40*; 400) in order to generate said reference voltage (Vref).

2. Electronic device according to claim 1 (or 2), **characterised in that** said measuring branch (20) includes:
- a first MOS transistor (M1) including a control electrode (g1) and first and second current electrodes (d1; s1);
- a first capacitive element (C0) mounted in series between the output (11; 11a) of the electronic device and the control electrode of the first transistor (M1);
- a first current source (SC1) mounted in series with said first transistor (M1) and generating a substantially constant current (i0);
- a first resistive element (R1) mounted between the first current electrode (d1) and the control electrode (g1) of said first transistor (M1); and
- a second capacitive element (Ca) mounted in parallel with said first transistor (M1) between its first and second current electrodes (d1; s1);
said measuring voltage (Vout) being generated at said first current electrode (d1) of the first transistor (M1);
the electronic device being further **characterised in that** said reference branch (40) includes:
- a second MOS transistor (M2) matched with said first transistor (M1) and including a control electrode (g2) and first and second current electrodes (d2; s2);
- a capacitive divider (45) including third and fourth capacitive elements (C1; C2) mounted in series between an input terminal (A) and a reference potential (Vss) and switching means (SW) for selectively applying said voltage reference (U0) and said reference potential (Vss) to said input terminal (A) of the capacitive divider (45), an intermediate terminal (B) of said capacitive divider (45) being connected to the control electrode (g2) of said second transistor (M2);
- a second current source (SC2) mounted in series with said second transistor (M2) and also generating said substantially constant current (i0);
- a second resistive element (R2) of substantially equal value to said first resistive element (R1) mounted between the first current electrode (d2) and the control electrode (g2) of said second transistor (M2); and
- a fifth capacitive element (Cb) mounted in parallel with said second transistor (M2) between its first and second current electrodes (d2; s2);
said reference voltage (Vref) being generated at said first current electrode (d2) of the second transistor (M2).

3. Electronic device according to claim 1 (or 2), **characterised in that** said measuring branch (20*; 201) includes:
- a first bipolar transistor (BP1; BP10) including a control electrode (b1) and first and second current electrodes (e1; c1);
- a first capacitive element (C0; C01) mounted in series between the output (11; 11a) of the electronic device and the control electrode (b1) of the first transistor (BP1; BP10);
- a first current source (SC1) mounted in series with said first transistor (BP1; BP10) and generating a substantially constant current (i0)
- a first resistive element (R1; R10) mounted between the first control electrode (b1) of said first transistor (BP1; BP10) and a biasing potential (Vpol); and
- a second capacitive element (Ca; Ca1) mounted in parallel with said first transistor (BP1; BP10) between its first and second current electrodes (e1; c1);
said measuring voltage (Vout) being generated at said first current electrode (e1) of the first transistor (BP1; BP10);
the electronic device being further **characterised in that** said reference branch (40*; 400) includes:
- a second bipolar transistor (BP2; BP20) matched with said first transistor (BP1; BP10) and including a control electrode (b2) and first and second current electrodes (e2, c2);
- a capacitive divider (45) including third and fourth capacitive elements (C1; C2) mounted in series between an input terminal (A) and a reference potential (Vss), and switching means (SW) for selectively applying said voltage reference (U0) and said reference potential (Vss) to said input terminal (A) of the capacitive divider (45), an intermediate terminal (B) of said capacitive divider (45) being connected to the control electrode (b2) of said second transistor (BP2; BP20);
- a second current source (SC2) mounted in series with said second transistor (BP2; BP20) and also generating said substantially constant current (i0);
- a second resistive element (R2; R20) of substantially equal value to said first resistive element (R1; R10) mounted between the control electrode (b2) of said second transistor (BP2; BP20) and said biasing potential (Vpol); and
- a fifth capacitive element (Cb) mounted in parallel with said second transistor (BP2; BP20) between its first and second current electrodes (e2; c2);
said reference voltage (Vref) being generated at said first current electrode (e2) of the second transistor (BP2; BP20).

4. Electronic device according to claim 3, **characterised in that** said bipolar transistors (BP1, BP2; BP10, BP20) are un**characterised** vertical bipolar transistors.

5. Electronic device according to claim 2 or 3, **characterised in that** the sum of the capacitance values of said third and fourth capacitive elements (C1; C2) is substantially equal to the capacitance value of said first capacitive element (C0; C01).

6. Electronic device according to any one of the preceding claims, **characterised in that** the electronic device is an oscillator circuit including first and second outputs (11a; 11b) generating respectively a first oscillation signal (Sosc) which is applied on said measuring branch (201) and a second oscillation signal (Sosc. b), phase shifted by 180° with respect to the first oscillation signal, which is applied on a second branch (202) matched with said measuring branch (201) in order to load said first and second outputs (11a, 11b) of the oscillator circuit symmetrically.

7. Electronic device according to claim 1, **characterised in that** it further comprises oscillation detecting means (500) for detecting the activity of said electronic device and, in case said electronic device is not generating any alternating output signal (S1, Sosc), for acting on said control signal (Sc) so as to allow start-up of said electronic device.

8. Electronic device according to claim 7, **characterized in that** said oscillation detection means (500) include means (M500) for bringing said reference voltage (Vref) to a determined value (Vss) which is different from the value of said measuring voltage (Vout) in case said electronic device is not generating any alternating output signal (S1, Sosc).
